Europäisches Patentamt

European Patent Office

Office européen des brevets

(11) Publication number: **0 031 995**
**B1**

# EUROPEAN PATENT SPECIFICATION

(45) Date of publication of patent specification: **26.02.86**

(51) Int. Cl.⁴: **G 11 C 7/00, G 11 C 11/40**

(21) Application number: **80304189.6**

(22) Date of filing: **21.11.80**

(54) Semiconductor RAM device comprising a matrix of static memory cells.

(30) Priority: **29.11.79 JP 154578/79**

(43) Date of publication of application:
**15.07.81 Bulletin 81/28**

(45) Publication of the grant of the patent:
**26.02.86 Bulletin 86/09**

(84) Designated Contracting States:
**DE FR GB NL**

(56) References cited:
**US-A-3 879 621**

**IBM TECHNICAL DISCLOSURE BULLETIN, vol. 13, no. 6, November 1970, pages 1720-1722, New York, USA, "Sense amplifier for igfet memory"**

**ELECTRONICS, vol. 52, no. 20, 27th September 1979, pages 131-139, New York, USA, D.HOFFMAN:"Polysilicon-load RAMs plug into mainframes or microprocessors"**

**IEEE JOURNAL OF SOLID-STATE CIRCUITS, vol. SC-11, no. 5, October 1976, pages 602-609, New York, USA;J.M. SCLAGETER et al:"Two 4K static 5-V RAMs"**

(73) Proprietor: **FUJITSU LIMITED**
**1015, Kamikodanaka Nakahara-ku Kawasaki-shi Kanagawa 211 (JP)**

(72) Inventor: **Kurafuji, Setsuo**
**2-5, Edakita 2-chome Midori-ku Yokohama-shi Kanagawa 227 (JP)**

(74) Representative: **Abbott, Leonard Charles et al GILL JENNINGS & EVERY 53-64 Chancery Lane London WC2A 1HN (GB)**

(56) References cited:
**IBM TECHNICAL DISCLOSURE BULLETIN, vol. 16, no. 9, February 1974, pages 2792-2793, New York, USA; A. FURMAN et al:"Sense latch circuit for memory cells"**

Courier Press, Leamington Spa, England.

## Description

The present invention relates to a semiconductor RAM (Random Access Memory) device, more particularly to a static-type RAM device.

A semiconductor memory having a sense amplifier, or latch, is disclosed in US—A— 3879621, in which a plurality of row lines permits the selection of individual memory cells of a column of memory cells for read-out. The sense amplifier is connected to bit lines of the column through gate circuits. The bit lines are precharged and the gate circuits, in response to control signal, couple the sense amplifier to the bit lines, so that the sense amplifier tracks the bit line potential when a bit line is discharged by the selection of a memory cell by a row line. Thereafter, the gate circuits disconnect the sense amplifier from the bit lines, and thereby isolate the bit lines.

In recent years, the memory capacity and the degree of integration of semiconductor memory devices have become very large. This is because it has become possible to make a great number of elements of very small size on one chip, due to recent technical development in the manufacture of integrated circuits. In a semiconductor memory device, such as a static-type semiconductor RAM device having flip-flop type memory cells, the size of each of the memory cells has become very small.

However, in a conventional static type RAM device in which each of the memory cells drives a sense amplifier directly through bit lines and data bus lines, there occurs a problem in that the read-out speed of the RAM device is decreased and the reliability of read-out data is decreased. This is because, according to the increase of the integration degree of the semiconductor memory device, the chip size of each of the memory cells is small and, especially in a case of a static-type memory cell, the size of the driver transistors included in each of the memory cells is small, so that the drive capacity of each of the memory cells decreases. Moreover, the stray capacitance of the bit lines and the data bus lines, which are driven by the memory cells and which form load circuits of the memory cells, does not decrease in accordance with the increase of the integration degree of the RAM device. Therefore, the amplitude of a read-out signal from a memory cell becomes small, so that the reliability of the read-out data is decreased; and the time necessary to change the potential on each of the bit lines and the data bus lines becomes large, because it takes a long time to charge or discharge the stray capacitance of these lines by a memory cell having a small drive capacity. Therefore, the read-out time of the RAM device increases according to the increase in the integration degree of the RAM device.

It is the principal object of the present invention to increase the read-out speed of a static RAM device having a large memory capacity and to improve the reliability of the data read-out.

The present invention consists in a semiconductor RAM device having a plurality of static-type memory cells which are disposed in a matrix of rows and columns and each of which is selected by an output from a row decoder and an output from a column decoder in response to input address signals and comprising a latch amplifier circuit coupled to the memory cells through gate circuits which are operated by a control pulse so that the latch amplifier circuit receives, through the gate circuits a data signal corresponding to the state of a selected memory cell, characterized in that a separate latch amplifier circuit is provided for each column and in that the device further comprises a control pulse generating circuit which, in response to a potential change of at least one of the input address signals, generates the control pulse after a predetermined delay, and in that the latch amplifier circuit is activated after the data signal has been fed to the latch amplifier circuit through the gate circuits under the control of the control pulse. Preferably, the amplifier circuits have a larger drive capacity than that of the memory cells, so as to prevent the slow down of the read-out speed of such a device with a large memory capacity.

In order that the invention may be better understood, some embodiments of the invention will now be described with reference to the accompanying drawings, in which:—

Figure 1 is a block circuit diagram illustrating a static type semiconductor RAM device according to the present invention.

Figure 2 is a circuit diagram illustrating a memory cell used in the RAM device of Figure 1.

Figure 3 is a block circuit diagram illustrating a gate signal generator used in the RAM device of Figure 1.

Figure 4 is a timing diagram illustrating the signals appearing in the circuits of Figs. 1 and 3.

Fig. 5 is a circuit diagram illustrating a sense amplifier used in the RAM device of Fig. 1.

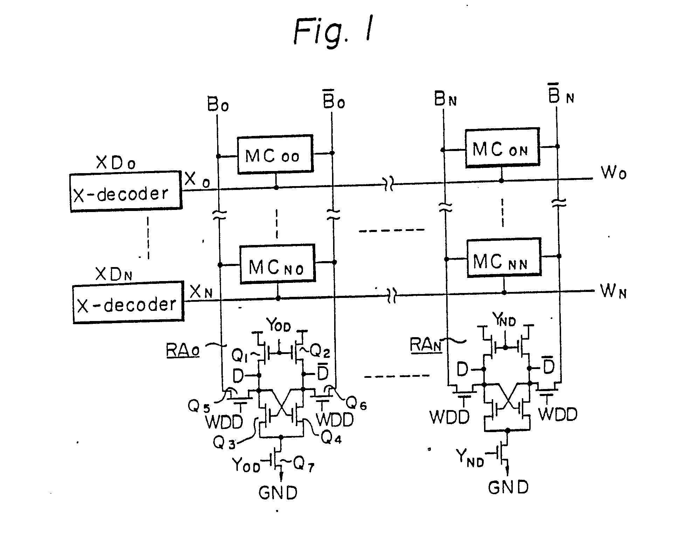

Fig. 1 illustrates a static type semiconductor RAM device in accordance with an embodiment of the present invention. In Fig. 1, memory cells $MC_{00}$ through $MC_{NN}$ are disposed in a matrix of N rows by N columns and each of the memory cells consists mainly of a flip-flop, which will be explained later in detail. Word lines $W_0$ through $W_N$ are connected to X address (or row address) decoders $XD_0$ through $XD_N$ respectively, and each of the word lines $W_0$ through $W_N$ is selected by corresponding one of the output signals $X_0$ through $X_N$ from the X address decoders $XD_0$ through $XD_N$. A plurality of bit line pairs $B_0$, $\overline{B}_0$ through $B_N$, $\overline{B}_N$ are crossed with a plurality of the word lines $W_0$ through $W_N$ to form the matrix. At each cross position of the matrix, one of the memory cells $MC_{00}$ through $MC_{NN}$ is connected between a bit line pair and a word line. These bit line pairs $B_0$, $\overline{B}_0$ through $B_N$, $\overline{B}_N$ are connected to latch circuits or amplifier circuits $RA_0$ through $RA_N$ respectively, according to the present invention. All the latch circuits $RA_0$ through $RA_N$ have the same structure, and therefore only the latch circuit $RA_0$ will be explained hereinafter. The latch circuit $RA_0$ comprises load transistors $Q_1$, $Q_2$ and driver transistors $Q_3$, $Q_4$ which compose a flip-flop. The latch circuit $RA_0$ further comprises gate transistors $Q_5$ and $Q_6$ connected between the bit line pair $B_0$, $\bar{B}_0$ and the flip-flop, and a switching transistor $Q_7$. The switching transistor $Q_7$ and the load transistors $Q_1$ and $Q_2$ are turned on and off by a signal $Y_{0D}$ which is a delayed signal of an output signal $Y_0$ from a Y address (or column address) decoder, not shown in the drawing. The gate transistors $Q_5$ and $Q_6$ are turned on and off by a delayed gate signal WDD produced in a gate signal generator, which will be explained later. Therefore, the latch circuits $RA_0$ through $RA_N$ are selected by the delayed gate signal WDD and the delayed output signal $Y_{0D}$ through $Y_{ND}$ of the output signal $Y_0$ through $Y_N$ from the Y address decoders, not shown in the drawing. The flip-flop of each of the above-mentioned latch circuits $RA_0$ through $RA_N$ has the same structure as that of each of the memory cells $MC_{00}$ through $MC_{NN}$, which will be explained later. However, it should be noted that the drive capacity of the driver transistors $Q_3$ and $Q_4$ of each of the latch circuits is larger than that of the driver transistors of the flip-flop contained in each of the memory cells $MC_{00}$ through $MC_{NN}$. Therefore, for example, the size of the driver transistors $Q_3$ and $Q_4$ of each of the latch circuits is larger than that of the driver transistors of each of the memory cells $MC_{00}$ through $MC_{NN}$.

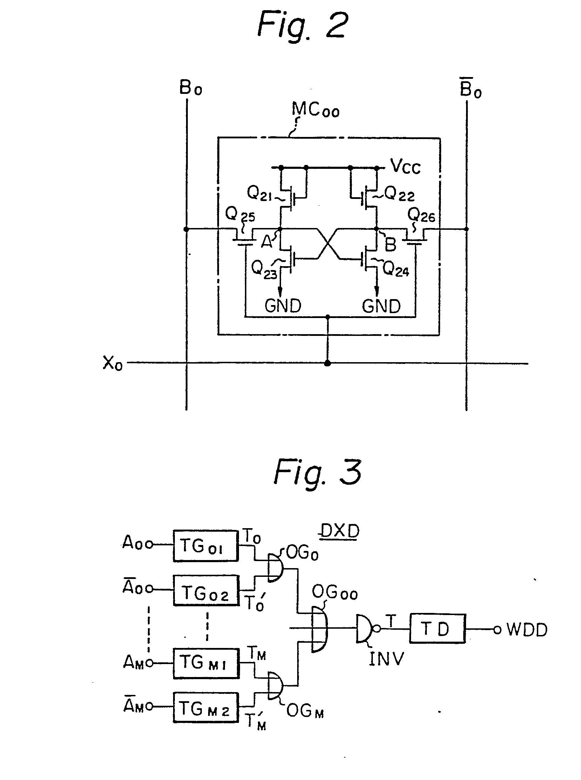

Fig. 2 illustrates a memory cell for example $MC_{00}$, used in the circuit of Fig. 1. The memory cell $MC_{00}$ comprises load transistors $Q_{21}$, $Q_{22}$ and driver transistors $Q_{23}$, $Q_{24}$ which compose a flip-flop, and gate transistors $Q_{25}$, $Q_{26}$ which are turned on and off by the output signal, i.e., decoded address signal $X_0$ from the X address decoder $XD_0$. When a read-out or a write-in of information is effected, the gate transistors $Q_{25}$ and $Q_{26}$ are turned on due to the supply of a decoded address signal $X_0$ of high potential level, and transfer of information between the bit lines $B_0$, $\bar{B}_0$ and the flip-flop of the memory cell $MC_{00}$ is effected.

Fig. 3 illustrates a gate signal generator which produces a delayed gate signal WDD and which comprises a detector circuit DXD consisting of trigger pulse generators $TG_{01}$, $TG_{02}$, ..., $TG_{M1}$, $TG_{M2}$, OR gates $OG_0$, ..., $OG_M$, $OG_{00}$ and an inverter INV, and, a delay circuit TD. Each of the trigger pulse generators $TG_{01}$ through $TG_{M2}$ detects potential change, i.e. leading edge or trailing edge, of the respective buffered address signals $A_0$, $\bar{A}_0$, ..., $A_M$, $\bar{A}_M$ and generates respective trigger pulses $T_0$, $T'_0$, ..., $T_M$, $T'_M$ when the potential change is detected. OR gates $OG_0$ through $OG_M$ and an OR gate $OG_{00}$ effect the logical "or" operation of the trigger pulses $T_0$, $T'_0$, ..., $T_M$, $T'_M$. The inverter INV inverts an output signal from the OR gate $OG_{00}$ and produces a gate signal T. A delay circuit TD delays the gate signal T for a predetermined time period and produces the delayed gate signal WDD, which was mentioned before. The delay time of the delay circuit TD is a time in which the output signal $X_0$, ..., $X_{N-1}$ or $X_N$ respectively reaches from the X address decoder $XD_0$, ..., $XD_{N-1}$ or $XD_N$ to the farthest end of the word line $W_0$, ..., $W_{N-1}$ or $W_N$, i.e., a portion of the word line to which the memory cell $MC_{0N}$, ..., $MC_{N-1\ N}$ or $MC_{NN}$ is connected in the embodiment of Fig. 1. Therefore, the delay circuit TD can be constructed by using a dummy word line which has approximately the same length as that of each of the word lines $W_0$ through $W_N$ and which is disposed parallel to the word lines $W_0$ through $W_N$. In the above-mentioned detector circuit, each of the trigger pulse generators $TG_{01}$ through $TG_{M2}$ can be constructed by using, for example, a differentiation circuit and a wave shaping circuit.

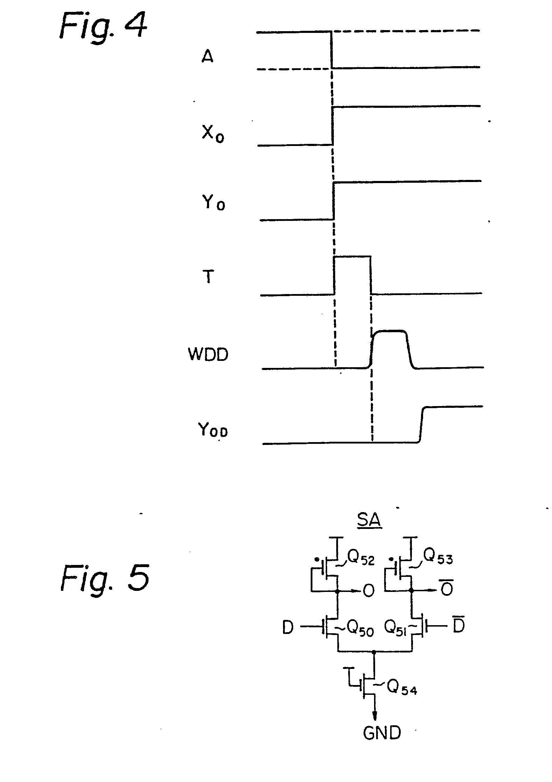

With reference to Fig. 4, the operation of the memory device according to this embodiment. will now be explained. When the read-out of information from a memory cell of the memory device is effected, input address signals $A_0$, $A_1$, ..., $A_M$ designating the memory cell are applied to address.buffer circuits, which are not shown in the drawings. The address buffer circuits produce buffered address signals $A_0$, $\bar{A}_0$, ..., $A_M$, $\bar{A}_M$ containing non-inverted signals and inverted signals of the input address signals. A part of the address signals $A_0$, $\bar{A}_0$, ..., $A_M$, $\bar{A}_M$ are applied to the X address decoders $XD_0$ through $XD_N$ and a part of the address signals are applied to Y address decoders, which are not shown in the drawings. When the memory cell, for example $MC_{00}$, is selected, the output $X_0$ from the X address decoder $XD_0$ turns to high and the output $Y_0$ from the Y address decoder turns to high. Before the output $X_0$ and the output $Y_0$ turn to high, at least two of the address signals $A_0$, $\bar{A}_0$, ..., $A_M$, $\bar{A}_M$ (i.e., at least a pair of the address signals including a noninverted and an inverted address signals) change their potential level, as illustrated by A of Fig. 4. This change of the potential level may be of a potential rise or a potential fall. In response to the change of the potential level of at least one address signal, the detector circuit DXD generates a gate signal T as illustrated in Fig. 4. The delay circuit TD delays the gate signal T and produces the delayed gate signal WDD, as illustrated in Fig. 4. The delayed gate signal WDD is applied to the gate electrodes of the transistors $Q_5$ and $Q_6$ of the latch circuits $RA_0$ through $RA_N$. Before the delayed gate signal WDD is generated, the potential of all portions of the selected word line $W_0$ has already risen to a high level. Therefore, the information from the memory cell $MC_{00}$, which is disposed in the nearest position from the X address decoder $XD_0$ in Fig. 1, has already been read out to the bit line pair $B_0$, $\bar{B}_0$. That is, the potentials of the point A and the point B in the memory cell $MC_{00}$ has already been transferred to the bit lines $B_0$ and $\bar{B}_0$ respectively. In such a condition, the gate transistors $Q_5$ and $Q_6$ are turned on by the delayed gate signal WDD and the information of the

memory cell $MC_{00}$, i.e. the potentials of the point A and the point B of the memory cell $MC_{00}$, is input to the latch circuit $RA_0$ through the gate transistors $Q_5$ and $Q_6$. After the delayed gate signal WDD is applied to the gate transistors $Q_5$ and $Q_6$, the delayed Y decoder signal $Y_{0D}$ is applied to the gate electrodes of the switching transistor $Q_7$ and the load transistors $Q_1$ and $Q_2$ of the latch circuit $RA_0$, so that the latch circuit $RA_0$ is activated, due to the supply of an operating voltage. Therefore, the latch circuit $RA_0$ is set to a condition determined by the input potentials, i.e. the potentials of the bit lines $B_0$ and $\bar{B}_0$, so that the transferring of information to the latch circuit $RA_0$ is effected. In this case, stray capacitances existing between the input circuit portion of the latch circuit $RA_0$ and the ground are charged by the potentials of the bit lines $B_0$ and $\bar{B}_0$. Therefore, even if the delayed Y decoder signal $Y_{0D}$ is applied to the latch circuit $RA_0$ a short time after the delayed gate signal WDD has changed from high potential to low potential, as illustrated in Fig. 4, it is possible to set the latch circuit $RA_0$ to a condition determined by the potentials of the bit lines $B_0$ and $\bar{B}_0$. It should be noted that the delayed gate signal WDD and the delayed Y decoder signal $Y_{0D}$ are needed in order to prevent the destruction of data in the memory cell $MC_{00}$. If the gate transistors $Q_5$ and $Q_6$ are always turned on, due to the supply of DC voltage of high potential instead of the delayed gate signal WDD, or if the latch circuit $RA_0$ is activated by the Y decoder signal $Y_0$, instead of the delayed Y decoder signal $Y_{0D}$, the memory cell $MC_{00}$ having a small drive capacity is written-in by the potentials of the bit lines $B_0$ and $\bar{B}_0$ which are determined by the condition of the latch circuit $RA_0$ at the time the memory cell $MC_{00}$ is selected.

Therefore, there is a possibility of the destruction of the data stored in the memory cell, for example, $MC_{00}$. In order to prevent the destruction of the data stored in each of the memory cells, it is necessary to use the delayed gate signal WDD and the delayed Y decoder signal $Y_{0D}$, as mentioned before, so that the potentials of the bit lines are determined by the selected memory cell and the latch circuit is set to the condition determined by the potentials of the bit lines due to the supply of the potentials of the bit lines.

Fig. 5 illustrates an example of a sense amplifier SA which is used in the memory device of Fig. 1. The sense amplifier SA comprises a pair of transistors $Q_{50}$ and $Q_{51}$ composing a differential amplifier, a pair of load transistors $Q_{52}$ and $Q_{53}$, and a transistor $Q_{54}$ composing a constant current source. The gate electrodes of the transistors $Q_{50}$ and $Q_{51}$ are respectively connected to the output terminals of the latch circuits $RA_0$ through $RA_N$ through data bus lines which are not shown in the drawings. Therefore, the output signals D and $\bar{D}$ of the latch circuit, for example, $RA_0$ are respectively applied to the gate electrodes of the transistors $Q_{50}$ and $Q_{51}$, and amplified by the sense amplifier SA. The sense amplifier SA provides output signals O and $\bar{O}$ as the read-out signals from the memory device.

In all these devices, the data bus lines and the sense amplifier are driven by the latch circuits, whose driver transistors are big in size, so as to obtain a large drive capacity so that it is possible to increase the read-out speed and to improve the reliability of the read-out data of the static type RAM device. Therefore, it is not necessary to use memory cells having big sizes and a latch circuit is provided for every column, so that the integration degree of the RAM device is not so much decreased.

**Claims**

1. A semiconductor RAM device having a plurality of static-type memory cells (MC) which are disposed in a matrix of rows and columns and each of which is selected by an output (Xo, Xn) from a row decoder (XDo, XDn) and an output from a column decoder in response to input address signals (Ao, $\bar{A}$o; Am, $\bar{A}$m; Figure 3), and comprising a latch amplifier circuit (RAo, RAn) coupled to the memory cells through gate circuits (Q5, Q6) which are operated by a control pulse (WDD) so that the latch amplifier circuit receives, through the gate circuits, a data signal corresponding to the state of a selected memory cell, characterized in that a separate latch amplifier circuit is provided for each column and in that the device further comprises a control pulse generating circuit (DXD, TD) which, in response to a potential change of at least one of said input address signals, generates said control pulse (WDD) after a predetermined delay, and in that the latch amplifier circuit is activated after the data signal has been fed to the latch amplifier circuit through the gate circuits (Q5, Q6) under the control of the control pulse (WDD).

2. A semiconductor RAM device as set forth in claim 1, wherein the predetermined delay is approximately equal to the time that the output signal (Xo, Xn) from the row decoder takes to reach the memory cell (MCon, MCnn) connected to the farthest end of a word line (Wo, Wn).

3. A semiconductor RAM device as set forth in claim 1 or 2, wherein the latch amplifier circuit (RAo, RAn) is activated by a delayed ($Y_{OD}$, $Y_{ND}$) signal derived from the output signal from the column decoder.

4. A semiconductor RAM device as set forth in claim 3, wherein the latch amplifier circuit (RAo, RAn) comprises: a pair of load transistors (Q1, Q2) whose bases are both connected to receive the said delayed signal ($Y_{OD}$) derived from the output signal from the column decoder; a flip-flop comprising a pair of driver transistors (Q3, Q4) connected to the said load transistors and to the said gate circuits (Q5, Q6) and a switching transistor (Q7), whose base is connected to receive the said delayed signal ($Y_{OD}$) in order to control the connection of the flip-flop to a reference potential (GND) and thereby the activation of the latch amplifier circuit.

5. A semiconductor RAM device as set forth in claim 4, wherein each of the driver transistors (Q3, Q4) of the latch amplifier circuit (RAo, RAn) has a larger drive capacity than that of the driver transistors (Q23, Q24) of the memory cells (MC).

6. A semiconductor RAM device as set forth in claim 4 or 5, wherein each of the driver transistors (Q3, Q4) of the latch amplifier circuit (RAo, RAn) has a greater size than that of the driver transistors (Q23, Q24) of the memory cells (MC).

7. A semiconductor RAM device according to any preceding claim further comprising a sense amplifier (SA) coupled to each latch amplifier circuit (RAo, RAn) and responsive to data signals (D, $\bar{D}$) from the latch amplifier circuits to produce read output signals (O, $\bar{O}$).

## Patentansprüche

1. Halbletier-RAM-Vorrichtung mit einer Vielzahl von statischen Speicherzellen (MC), welche in einer Matrix aus Reihen und Spalten angeordnet sind und von denen jede durch einen Ausgang (Xo, Xn) eines Reihendecoders (XDo, XDn) und eines Ausgangs eines Spaltendecoders in Abhängigkeit von Eingangsdressensignalen (Ao, $\bar{A}$o; Am, $\bar{A}$m; Fig. 3) ausgewählt wird, und mit einer Halteverstärkerschaltung (RAo, RAn), welche mit den Speicherzellen über Torschaltungen (Q5, Q6) verbunden ist, die durch einen Steuerimpuls (WDD) betätigt werden so daß die Halteverstärkerschaltung über die Torschaltungen ein Datensignal empfängt, welches dem Zustand einer ausgewählten Speicherzelle entspricht, dadurch gekennzeichnet, daß eine separate Halteverstärkerschaltung für jede Spalte vorgesehen ist und daß die Vorrichtung ferner eine Steuerimpulsgeneratorschaltung (DXD, TD) umfaßt, welche in Abhängigkeit von der Potentialänderung von wenigstens einem der genannten Adressensignale den genannten Steuerimpuls (WDD) nach einer vorbestimmten Verzögerung erzeugt, und daß die Halteverstärkerschaltung aktiviert wird, nachdem das Datensignal über die Torschaltungen (Q5, Q6) unter der Steuerung des Steuerimpulses (WDD) der Halteverstärkerschaltung zugeführt worden ist.

2. Halbleiter-RAM-Vorrichtung nach Anspruch 1, bei welcher die vorbestimmte Verzögerung etwa gleich der Zeit ist, welche das Ausgangssignal (Xo, Xn) des Reihendecoders benötigt, um die Speicherzelle (MCon, MCnn) zu erreichen, welche mit dem entferntesten Ende einer Wortleitung (Wo, Wn) verbunden ist.

3. Halbleiter-RAM-Vorrichtung nach Anspruch 1 oder 2, bei welcher die Halteverstärkerschaltung (RAo, RAn) durch eine verzögertes (Y$_{OD}$, Y$_{ND}$) Signal aktiviert wird, welches von dem Ausgangssignal des Spaltendecoders abgeleitet ist.

4. Halbleiter-RAM-Vorrichtung nach Anspruch 3, bei welcher die Halteverstärkerschaltung (RAo, RAn) umfaßt: eine Paar von Lasttransistoren (Q1, Q2), deren Basen beide zum Empfang des genannten vorzögerten Signals (Y$_{OD}$) ange-

schlossen sind, welches von dem Ausgangssignal des Spaltendecoders abgeleitet ist; ein Flip-Flop, welches ein Paar von Treibertransistoren (Q3, Q4) umfaßt, die mit den genannten Lasttransistoren und mit den genannten Torschaltungen (Q5, Q6) und einem Schalttransistor (Q7) verbunden sind, dessen Basis zum Empfang des genannten verzögerten Signals (Y$_{OD}$) angeschlossen ist, um die Verbindung des Flip-Flops mit einem Referenzpotential (GND) und dadurch die Aktivierung der Halteverstärkerschaltung zu steuern.

5. Halbleiter-RAM-Vorrichtung nach Anspruch 4, bei welcher jeder der Treibertransistoren (Q3, Q4) der Halteverstärkerschaltung (RAo, RAn) eine größere Treiberkapazität als die Treibertransistoren (Q23, Q24) der Speicherzellen (MC) hat.

6. Halbleiter-RAM-Vorrichtung nach Anspruch 4 oder 5, bei welcher jeder der Treibertransistoren (Q3, Q4) der Halteverstärkerschaltung (RAo, RAn) eine größere Größe als die Treibertransistoren (Q23, Q24) der Speicherzellen (MC) hat.

7. Halbleiter-RAM-Vorrichtung nach einem der vorhergehenden Ansprüche, ferner mit einem Leseverstärker (SA), der mit jeder Halteverstärkerschaltung (RAo, RAn), verbunden ist und auf Datensignale (D, $\bar{D}$) von den Halteverstärkerschaltungen anspricht, um Auslesesignale (O, $\bar{O}$) zu erzeugen.

## Revendications

1. Dispositif de mémoire vive (RAM) à semiconducteurs comportant un ensemble de cellules de mémoire du type statiques (MC) qui sont disposées selon une matrice de rangées et de colonnes, chaque cellule étant sélectionnée par un signal de sortie (Xo, Xn) d'un décodeur de rangée (XDo, XDn) et par un signal de sortie d'un décodeur de colonne en réponse à des signaux d'adresse d'entrée (Ao, $\bar{A}$o; Am, $\bar{A}$m; Figure 3) et comprenant un circuit amplificateur à bascule (RAo, RAn) relié aux cellules de mémoire par l'intermédiaire de circuits de déclenchement (Q5, Q6) qui sont mis en fonctionnement par une impulsion de commande (WDD) de sorte que le circuit amplificateur à bascule reçoit, par l'intermédiaire des circuits de déclenchement, un signal de donnée correspondant à l'état d'une cellule de mémoire sélectionnée, caractérisé en ce qu'un circuit amplificateur à bascule séparé est prévu pour chaque colonne et en ce que le dispositif comprend en outre un circuit générateur d'impulsions de commande (DXD, TD) qui, en réponse à une variation de tension d'au moins un des signaux d'adresse d'entrée, engendre l'impulsion de commande (WDD) après un retard prédéterminé, et en ce que le circuit amplificateur à bascule est rendu actif après que le signal de donnée ait été au circuit amplificateur à bascule par l'intermédiaire des circuits de déclenchement (Q5, Q6) sous la commande de l'impulsion de commande (WDD).

2. Dispositif de mémoire RAM à semiconducteurs selon la revendication 1, caractérisé en ce que le retard prédéterminé est à peu près égal au temps pris par le signal de sortie (Xo, Xn) du décodeur de rangée pour atteindre la cellule de mémoire (MCon, MCnn) connectée à l'extrémité la plus éloignée d'une ligne de mots (MCon, MCnn).

3. Dispositif de mémoire RAM à semiconducteurs selon la revendication 1 ou 2 caractérisé en ce que le circuit amplificateur à bascule (RAo, RAn) est rendu actif par un signal retardé ($Y_{OD}$, $Y_{ND}$) dérivé du signal de sortie du décodeur de colonne.

4. Dispositif de mémoire RAM à semiconducteurs selon la revendication 3, caractérisé en ce que le circuit amplificateur à bascule (RAo, RAn) comprend: une paire de transistors de charge ($Q1$, $Q2$) dont les bases sont connectées ensemble pour recevoir le signal retardé ($Y_{OD}$) dérivé du signal de sortie du décodeur de colonne; une bascule comprenant une paire de transistors de commande ($Q3$, $Q4$) connectés aux transistors de charge et aux circuits de déclenchement ($Q_5$, $Q_6$); et un transistor de commutation ($Q7$) dont la base est connectée pour recevoir le signal retardé ($Y_{OD}$) afin de régler la connexion de la bascule à une tension de référence (MASSE) et de rendre ainsi actif le circuit amplificateur à bascule.

5. Dispositif de mémoire RAM à semiconducteurs selon la revendication 4, caractérisé en ce que chacun des transistors de commande ($Q_3$, $Q_4$) du circuit amplificateur à bascule (RAo, RAn) a une capacité d'excitation supérieure à celle des transistors de commande ($Q23$, $Q24$) de la cellule de mémoire (MC).

6. Dispositif de mémoire RAM à semiconducteurs selon l'une quelconque des revendications 4 et 5, caractérisé en ce que chacun des transistors de commande ($Q_3$, $Q_4$) du circuit amplificateur à bascule (RAo, RAn) a des dimensions plus grandes que celles des transistors de commande ($Q23$, $Q24$) des cellules de mémoire (MC).

7. Dispositif de mémoire RAM à semiconducteurs selon l'une quelconque des revendications 1 à 6, caractérisé en ce qu'il comprend en outre un amplificateur de détection (SA) relié à chaque circuit amplificateur à bascule (RAo, RAn) et sensible à des signaux de données (D, $\bar{D}$) provenant des circuits amplificateurs à bascule pour produire des signaux de sortie de lecture (O, $\bar{O}$).

Fig. I

0 031 995

1

# *Fig. 2*

# *Fig. 3*

# Fig. 4

A

$X_0$

$Y_0$

T

WDD

$Y_{OD}$

# Fig. 5

SA

$Q_{52}$ $Q_{53}$

O $\overline{O}$

D $Q_{50}$ $Q_{51}$ $\overline{D}$

$Q_{54}$

GND